# EUROPEAN PATENT SPECIFICATION

(11) **EP 4 604 176 B1**
(45) Date of publication and mention of the grant of the patent: **30.09.2026**
(21) Application number: 24158351.7
(22) Date of filing: 19.02.2024
(51) Int. Cl.: H10W 76/15, H10W 76/40, H10W 76/47, H10W 90/00

(54) **SEMICONDUCTOR MODULE ARRANGEMENT, ELECTRONICS CARRIER FOR A SEMICONDUCTOR MODULE ARRANGEMENT, AND METHOD FOR PRODUCING A SEMICONDUCTOR MODULE ARRANGEMENT**
HALBLEITERMODULANORDNUNG, ELEKTRONIKMODUL FÜR EINE HALBLEITERMODULANORDNUNG UND VERFAHREN ZUM HERSTELLEN EINER HALBLEITERMODULANORDNUNG
ENSEMBLE MODULE SEMI-CONDUCTEUR, SUPPORT ÉLECTRONIQUE POUR UN ENSEMBLE MODULE SEMI-CONDUCTEUR ET PROCÉDÉ DE FABRICATION D'UN ENSEMBLE MODULE SEMI-CONDUCTEUR

(43) Date of publication of application: 20.08.2025
(73) Proprietor: Infineon Technologies AG, 85579 Neubiberg (DE)
(72) Inventor: GOLDAMMER, Martin, 59494 Soest (DE); SCHMER, Alexander, 59494 Soest (DE); ARENS, Andre, 59602 Rüthen (DE)
(74) Representative: Westphal, Mussgnug & Partner, Patentanwälte mbB

(56) References cited:
- EP-A1- 4 486 079
- US-A1- 2002 031 672
- US-A1- 2005 198 819
- US-A1- 2016 294 083
- US-A1- 2023 282 530

## Description

### TECHNICAL FIELD

The instant disclosure relates to a semiconductor module arrangement, an electronics carrier for a semiconductor module arrangement, and to a method for producing a semiconductor module arrangement.

### BACKGROUND

Document US 2005/198819 A1 discloses a circuit board inserted into an open-ended housing. Potting material is dispensed onto the exposed face of the circuit board in a single step to seal the circuit board to the housing. One or more electrical interconnects such as a connector header or a ribbon cable attached to the circuit board extend upward through the potting material so that the potting material also forms an environmental seal around the electrical interconnects.

Document US 2016/294083 A1 discloses a circuit board having a socket with at least one plated through-hole. A connector includes a housing that has first and second connector interfaces with, respectively, at least first and second connector contacts. The first connector interface opens into an interior of the housing such that there is a vapor path through the first connector interface and the interior of the housing to the second connector contact at the second connector interface. A resilient seal is located at the first connector interface. The first connector contact extends through the resilient seal and into the plated through-hole. The resilient seal intimately seals around the first connector contact and provides a barrier at the first connector interface into the vapor path.

Document US 2002/031672 A1 discloses a packaging structure applied to an automotive component having semiconductors and electronic parts mounted on a ceramic base, wherein the semiconductors and electronic parts are partly or entirely sealed with a thixotropic silicone gel which has a thixotropy index of about 1.5-3.6 and a penetration depth of about 6-10 mm and a rate of change in viscosity of less than 10% of the initial value.

Semiconductor module arrangements often include at least one semiconductor substrate arranged in a housing. A semiconductor arrangement including a plurality of controllable semiconductor elements (e.g., two IGBTs in a half-bridge configuration) is arranged on each of the at least one substrate. Each substrate usually comprises a substrate layer (e.g., a ceramic layer), a first metallization layer deposited on a first side of the substrate layer and a second metallization layer deposited on a second side of the substrate layer. The controllable semiconductor elements are mounted, for example, on the first metallization layer. The second metallization layer may optionally be attached to a base plate. Some semiconductor module arrangements also include a printed circuit board arranged distant from and in parallel to the substrate. The printed circuit board may also be arranged inside the housing. A plurality of different electrical or electrically conducting components (e.g., semiconductor elements, terminal elements, connection elements, etc.) may be arranged on the substrate and/or on the printed circuit board. One or more connector elements may be arranged on the at least one substrate and/or on the printed circuit board. The one or more connector elements allow to electrically contact the substrate and/or the printed circuit board from the outside of the housing.

Semiconductor module arrangements often also comprise an encapsulant at least partly filling the interior of the housing, thereby covering the substrate and any semiconductor bodies arranged thereon, and also partly covering the one or more connector elements. In order to form the encapsulant, a liquid or viscous encapsulation material is filled into the housing and is subsequently hardened/cured. Before it is sufficiently hardened/cured, the liquid or viscous encapsulation material may penetrate into the one or more connector elements due to capillary effects or adhesion effect. As a result, electrical ports of the one or more connector elements may be at least partly coated by the encapsulation material. When subsequently corresponding counterparts are plugged into the one or more connector elements, any encapsulation material coating the electrical ports may result in a poor electrical connection between the one or more connector elements and their corresponding counterparts, or during the electrical test of the component, the measuring adapter may become contaminated There is a need for a semiconductor module arrangement, an electronics carrier for a semiconductor module arrangement, and a method for producing a semiconductor module arrangement which overcome the drawbacks outlined above.

### SUMMARY

An electronics carrier for a semiconductor module arrangement includes a connector element arranged on and electrically coupled to the electronics carrier, and a sealing gasket surrounding a lower end of the connector element, wherein the lower end is an end of the connector element facing the electronics carrier, and wherein a strand of sealing gasket extends around the entire circumference of the connector element and seals a gap between the lower end of the connector element and the electronics carrier. The connector element includes a plurality of electrical ports and an electrically insulating casing, wherein the casing provides a cavity surrounded by sidewalls of the connector element, and the electrical ports extend into the cavity with a first end, and wherein each of the plurality of electrical ports is partly molded into the electrically insulating casing.

A semiconductor module arrangement includes a housing, and an electronics carrier, wherein the electronics carrier is arranged inside the housing or forms a bottom of the housing.

A method includes arranging a connector element on an electronics carrier for a semiconductor module arrangement, forming a sealing gasket such that the sealing gasket surrounds a lower end of the connector element, wherein the lower end is an end of the connector element facing the electronics carrier, and wherein a strand of sealing gasket extends around the entire circumference of the connector element and seals a gap between the lower end of the connector element and the electronics carrier. The connector element includes a plurality of electrical ports and an electrically insulating casing, wherein the casing provides a cavity surrounded by sidewalls of the connector element, and the electrical ports extend into the cavity with a first end, and wherein each of the plurality of electrical ports is partly molded into the electrically insulating casing.

The invention may be better understood with reference to the following drawings and the description. The components in the figures are not necessarily to scale, emphasis instead being placed upon illustrating the principles of the invention. Moreover, in the figures, like referenced numerals designate corresponding parts throughout the different views.

### BRIEF DESCRIPTION OF THE DRAWINGS

Figure 1 is a cross-sectional view of a semiconductor module arrangement.
Figure 2 is a cross-sectional view of another semiconductor module arrangement.
Figure 3 is a side view of a connector element.
Figure 4 is a three-dimensional view of a connector element.
Figure 5 is a top view of a connector element.
Figure 6 is a cross-sectional view of a connector element and a sealing gasket arranged on a printed circuit board.
Figure 7 is a cross-sectional view of a semiconductor module arrangement according to embodiments of the disclosure.
Figure 8 is a cross-sectional view of a semiconductor module arrangement according to further embodiments of the disclosure.

### DETAILED DESCRIPTION

In the following detailed description, reference is made to the accompanying drawings. The drawings show specific examples in which the invention may be practiced. It is to be understood that the features and principles described with respect to the various examples may be combined with each other, unless specifically noted otherwise. In the description, as well as in the claims, designations of certain elements as "first element", "second element", "third element" etc. are not to be understood as enumerative. Instead, such designations serve solely to address different "elements". That is, e.g., the existence of a "third element" does not require the existence of a "first element" and a "second element". An electrical line or electrical connection as described herein may be a single electrically conductive element, or include at least two individual electrically conductive elements connected in series and/or parallel. Electrical lines and electrical connections may include metal and/or semiconductor material, and may be permanently electrically conductive (i.e., non-switchable). A semiconductor body as described herein may be made from (doped) semiconductor material and may be a semiconductor chip or be included in a semiconductor chip. A semiconductor body has electrically connecting pads and includes at least one semiconductor element with electrodes.

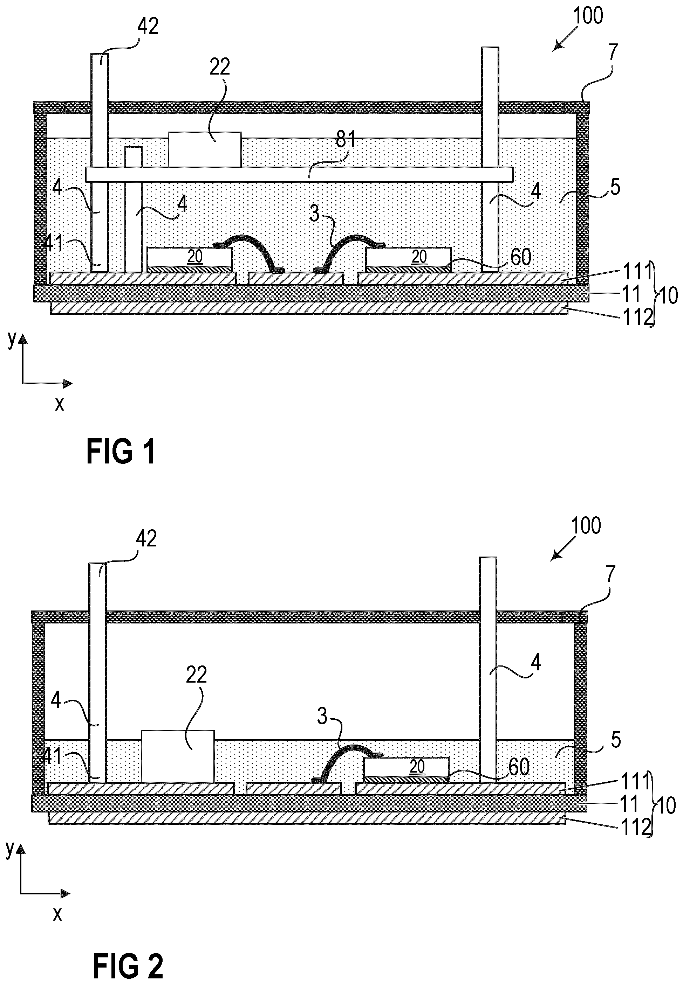

Referring to Figure 1, a cross-sectional view of a semiconductor module arrangement 100 is schematically illustrated. The semiconductor module arrangement 100 includes a housing 7 and an electronics carrier. The electronics carrier is implemented as a substrate 10. The substrate 10 includes a dielectric insulation layer 11, a (structured) first metallization layer 111 attached to the dielectric insulation layer 11, and a (structured) second metallization layer 112 attached to the dielectric insulation layer 11. The dielectric insulation layer 11 is disposed between the first and second metallization layers 111, 112.

Each of the first and second metallization layers 111, 112 may consist of or include one of the following materials: copper; a copper alloy; aluminum; an aluminum alloy; any other metal or alloy that remains solid during the operation of the semiconductor module arrangement. The substrate 10 may be a ceramic substrate, that is, a substrate in which the dielectric insulation layer 11 is a ceramic, e.g., a thin ceramic layer. The ceramic may consist of or include one of the following materials: aluminum oxide; aluminum nitride; zirconium oxide; silicon nitride; boron nitride; or any other dielectric ceramic. For example, the dielectric insulation layer 11 may consist of or include one of the following materials: Al₂O₃, AIN, SiC, BeO or Si₃N₄. For instance, the substrate 10 may, e.g., be a Direct Copper Bonding (DCB) substrate, a Direct Aluminum Bonding (DAB) substrate, or an Active Metal Brazing (AMB) substrate. Further, the substrate 10 may be an Insulated Metal Substrate (IMS). An Insulated Metal Substrate generally comprises a dielectric insulation layer 11 comprising (filled) materials such as epoxy resin or polyimide, for example. The material of the dielectric insulation layer 11 may be filled with ceramic particles, for example. Such particles may comprise, e.g., SiO₂, Al₂O₃, AIN, or BN and may have a diameter of between about 1µm and about 50µm. The electronics carrier may also be a conventional printed circuit board (PCB) having a non-ceramic dielectric insulation layer 11. For instance, a non-ceramic dielectric insulation layer 11 may consist of or include a cured resin.

The substrate 10 is arranged in a housing 7. In the example illustrated in Figure 1, the substrate 10 forms a ground surface of the housing 7, while the housing 7 itself solely comprises sidewalls and a cover or lid. This is, however, only an example. The cover or lid, for example, may also be omitted. It is also possible that the substrate 10 is arranged on a base plate which forms a ground surface of the housing 7, or that the housing 7 further comprises a ground surface and the substrate 10 and, optionally, the base plate be arranged inside the housing 7. In some semiconductor module arrangements 100, more than one substrate 10 is arranged on a single base plate 12 or on the ground surface of a housing 7.

One or more semiconductor bodies 20 may be arranged on the at least one substrate 10. Each of the semiconductor bodies 20 arranged on the at least one substrate 10 may include a diode, an IGBT (Insulated-Gate Bipolar Transistor), a MOSFET (Metal-Oxide-Semiconductor Field-Effect Transistor), a JFET (Junction Field-Effect Transistor), a HEMT (High-Electron-Mobility Transistor), and/or any other suitable semiconductor element.

The one or more semiconductor bodies 20 may form a semiconductor arrangement on the substrate 10. In Figure 1, only two semiconductor bodies 20 are exemplarily illustrated. The second metallization layer 112 of the substrate 10 in Figure 1 is a continuous layer. The first metallization layer 111 is a structured layer in the example illustrated in Figure 1. "Structured layer" means that the first metallization layer 111 is not a continuous layer, but includes recesses between different sections of the layer. Such recesses are schematically illustrated in Figure 1. The first metallization layer 111 in this example includes three different sections. This, however, is only an example. Any other number of sections is possible. Different semiconductor bodies 20 may be mounted to the same or to different sections of the first metallization layer 111. Different sections of the first metallization layer 111 may have no electrical connection or may be electrically connected to one or more other sections using electrical connections 3 such as, e.g., bonding wires. Electrical connections 3 may also include bonding ribbons, connection plates or conductor rails, for example, to name just a few examples. The one or more semiconductor bodies 20 may be electrically and mechanically connected to the substrate 10 by an electrically conductive connection layer 60. Such an electrically conductive connection layer 60 may be a solder layer, a layer of an electrically conductive adhesive, or a layer of a sintered metal powder, e.g., a sintered silver powder, for example.

According to other examples, it is also possible that the second metallization layer 112 is a structured layer. It is further possible to omit the second metallization layer 112 altogether. It is generally also possible that the first metallization layer 111 is a continuous layer, for example.

The semiconductor module arrangement 100 illustrated in Figure 1 further includes terminal elements 4. A first subset of the terminal elements 4 is electrically connected to the first metallization layer 111 and provides an electrical connection between the inside and the outside of the housing 7. The terminal elements 4 of the first subset may be electrically connected to the first metallization layer 111 with a first end 41, while a second end 42 of each of the terminal elements 4 of the first subset protrudes out of the housing 7. The terminal elements 4 of the first subset may be electrically contacted from the outside of the housing 7 at their respective second ends 42. A first part of the terminal elements 4 of the first subset may extend through the inside of the housing 7 in a vertical direction y. The vertical direction y is a direction perpendicular to a top surface of the substrate 10, wherein the top surface of the substrate 10 is a surface on which the at least one semiconductor body 20 is mounted. The terminal elements 4 illustrated in Figure 1, however, are only examples. Terminal elements 4 may be implemented in any other way and may be arranged anywhere within the housing 7. For example, one or more terminal elements 4 may be arranged further away from the sidewalls of the housing 7. The first end 41 of a terminal element 4 may be electrically and mechanically connected to the substrate 10 by an electrically conductive connection layer, for example (not explicitly illustrated in Figure 1). Such an electrically conductive connection layer may be a solder layer, a layer of an electrically conductive adhesive, or a layer of a sintered metal powder, e.g., a sintered silver (Ag) powder, for example. The first end 41 of a terminal element 4 may also be electrically coupled to the substrate 10 via one or more electrical connections 3, for example.

The semiconductor module arrangement 100 illustrated in Figure 1 further comprises an additional electronics carrier. The additional electronics carrier in this example is implemented as a printed circuit board 81. The printed circuit board 81 is arranged inside the housing 7 and may be coupled to the first subset of terminal elements 4 and may be further coupled to a second subset of terminal elements 4. The second subset of the terminal elements 4 may comprise shorter terminal elements that are arranged entirely inside the housing 7. The printed circuit board 81 may be electrically and mechanically coupled to the second ends 42 of the terminal elements of the second subset, for example. The first subset of terminal elements 4 may extend from the substrate 10 through a through hole in the printed circuit board 81 to the outside of the housing 7.

By arranging an additional electronics carrier such as a printed circuit board 81 inside the housing 7, the semiconductor module arrangement 100 can be implemented in a compact and space saving way, for example. This is, because at least a subset of a plurality of components that is usually arranged on the substrate 10 or on an external printed circuit board (printed circuit board that is arranged outside of the housing 7) can be arranged on the internal printed circuit board 81 instead of on the substrate 10 or an external printed circuit board. That is, some (or all) components can be arranged on the printed circuit board 81 inside the housing 7, while others (or none) are arranged on an (optional) external printed circuit board. The size of the substrate 10 and/or an external printed circuit board, therefore, can be reduced as compared to arrangements only comprising a substrate 10, or a substrate 10 and an external printed circuit board outside the housing 7 but not the printed circuit board 81 inside the housing 7.

The semiconductor module arrangement 100 further includes an encapsulant 5. The encapsulant 5 may consist of or include a silicone gel or may be a rigid molding compound, for example. The encapsulant 5 may at least partly fill the interior of the housing 7, thereby covering the components and electrical connections that are arranged on the substrate 10. In order to protect the printed circuit board 81 inside the housing 7 and the components arranged on the printed circuit board 81 from certain environmental conditions and mechanical damage, the printed circuit board 81, optionally, may also be covered by the encapsulant 5. The terminal elements 4 may be at least partly embedded in the encapsulant 5. At least the second ends 42 of the first subset, however, are not covered by the encapsulant 5 and protrude from the encapsulant 5 through the housing 7 to the outside of the housing 7. The encapsulant 5 is configured to protect the components and electrical connections of the semiconductor module 100, in particular the components arranged on the substrate 10 inside the housing 7, from certain environmental conditions and mechanical damage.

As has been described above, the substrate 10 and an internal printed circuit board 81 may be electrically coupled to the outside of the housing 7 by means of one or more terminal elements 4. However, for some applications, one or more connector elements 22 are provided that are configured to form (further) electrical connections to the outside of the housing 7. In Figure 1, one connector element 22 is schematically illustrated, the connector element 22 being arranged on the printed circuit board 81. Referring to Figure 2, a semiconductor module arrangement without a printed circuit board 81 is schematically illustrated. In this case, the connector element 22 is arranged on the substrate 10. That is, generally speaking, a semiconductor module arrangement according to embodiments of the disclosure comprises a connector element 22 arranged on an electronics carrier (substrate 10 or printed circuit board 81). In Figures 1 and 2, only one connector element 22 is exemplarily shown. A semiconductor module arrangement, however, may also comprise more than one connector element 22.

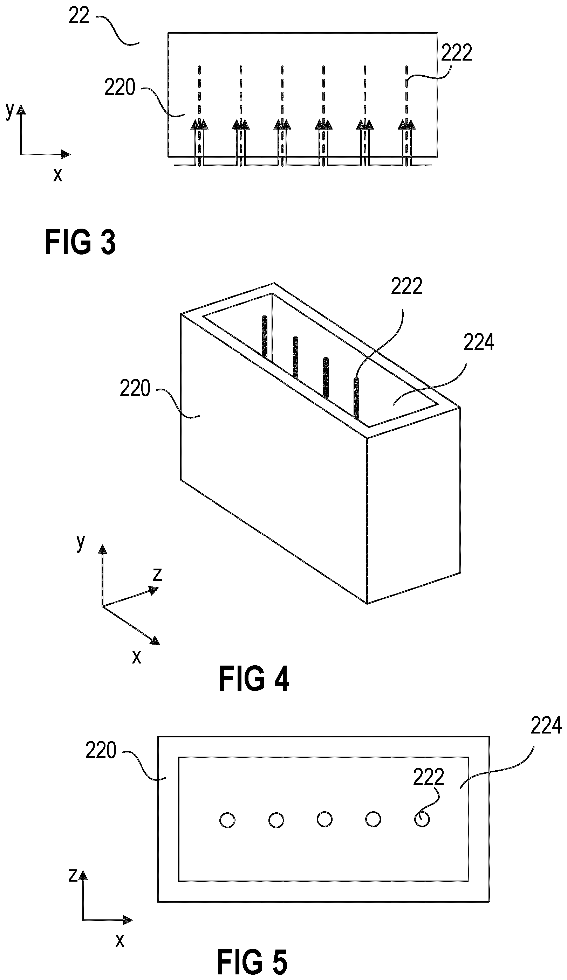

Connector elements 22 often comprise a plurality of electrical ports 222 and an electrically insulating casing 220, wherein each of the plurality of electrical ports 222 is partly molded into the electrically insulating casing 220. This is schematically illustrated in Figures 3, 4 and 5, wherein Figure 3 shows a side view, Figure 4 shows a three-dimensional view, and Figure 5 shows a top view of an exemplary connector element 22. A connector element 22 may be considered as a kind of socket. A corresponding counterpart may be plugged into the connector element 22 in order to electrically contact the semiconductor module arrangement 100 from outside of the housing 7. Connector elements 22 are generally comparably simple elements and are often produced by means of injection molding processes. By means of an injection molding process, the electrical ports 222 is partly molded into the material forming the casing 220. The casing 220 provides a cavity 224 surrounded by sidewalls of the connector element 22, and the electrical ports 222 extend into the cavity 224 with a first end. A second end of the electrical ports 222 may extend out of the casing 220 at a lower end (bottom) of the casing 220, wherein the lower end is an end of the connector element 22 configured to be connected to an electronics carrier 10, 81. With the electrical ports 222 extending through the casing 220, there is a risk that microscopic cavities remain between the electrical ports 222 and the casing 220. When the encapsulant 5 is formed, a liquid or viscous encapsulation material is filled into the housing 7 and is subsequently hardened to form the encapsulant 5. Any connector elements 22 arranged on the substrate 10 or the printed circuit board 81 are generally partly covered by encapsulation material. A top side of a connector element 22 generally remains free of encapsulation material such that it may be contacted by a corresponding counterpart. While the encapsulation material is still liquid or viscous, there is a risk that encapsulation material, due to capillary effects, enters the cavity 224 through microscopic cavities between the electrical ports 222 and the casing 220 (indicated by means of arrows in Figure 3). Such encapsulation material may at least partly coat the ends of the electrical ports 222 extending into the cavity 224, which may result in a poor electrical connection between the connector element 22 and a corresponding counterpart.

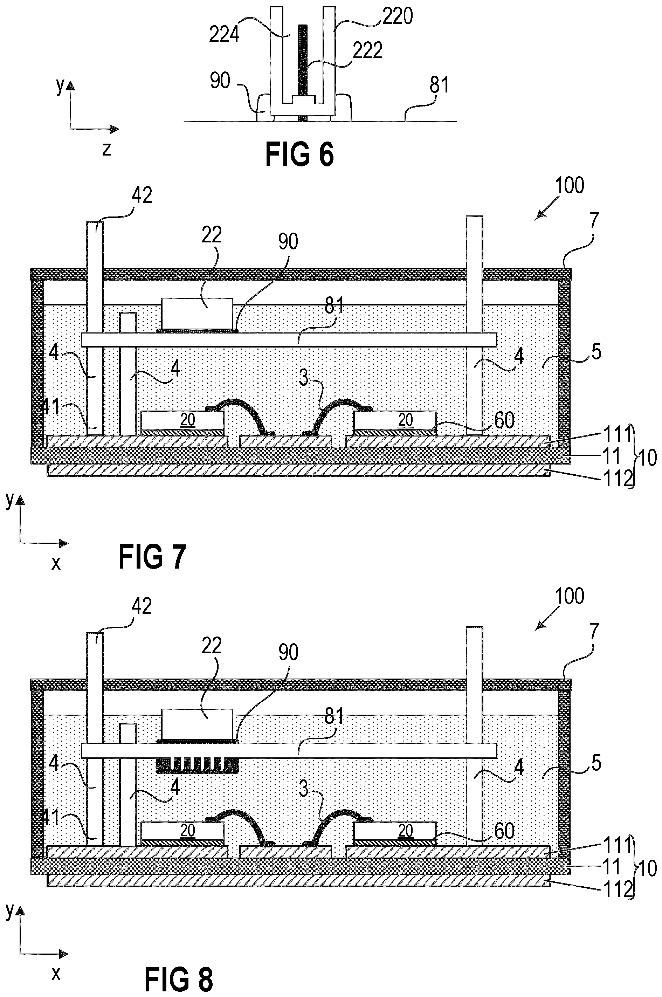

A semiconductor module arrangement 100 according to embodiments of the disclosure, therefore, comprises a housing 7, an electronics carrier 10, 81 arranged inside the housing 7 or forming a bottom of the housing 7, a connector element 22 arranged on and electrically coupled to the electronics carrier 10, 81, and a sealing gasket 90 surrounding a lower end of the connector element 22, wherein the lower end is an end of the connector element 22 facing the electronics carrier 10, and wherein the sealing gasket 90 is arranged to seal a gap between the lower end of the connector element 22 and the electronics carrier 10, 81. The sealing gasket 90 prevents the encapsulation material, when it is still liquid or viscous, from even reaching any microscopic cavities that may be present in the connector element 22 (e.g., between the electrical ports 222 and the casing 220). As the electrical ports 222 usually protrude out of the casing 220 on a bottom side of the connector element 22 (the bottom side being the side of the connector element 22 which faces the electronics carrier 10, 81), a strand of sealing gasket 90 extending around the entire circumference of the connector element 22 and sealing a gap between the connector element 22 and the electronics carrier 10, 81 may be sufficient to prevent any encapsulation material from entering into the connector element 22 and contaminating the electrical ports 222. That is, the sealing gasket 90 partly covers the sidewalls of the connector element 22 (i.e. of the casing 220), and further partly covers the electronics carrier 10, 81. This is schematically illustrated in Figure 6.

It is also possible that the sealing gasket 90 is partly arranged between the connector element 22 and the electronics carrier 10, 81. That is, the material that is used to form the sealing gasket 90 may penetrate into a gap between the lower end of the connector element 22 and the electronics carrier 10, 81 to a certain degree. This is also schematically illustrated in Figure 6.

The material that is used to form the sealing gasket 90, however, may have different properties as compared to the encapsulation material that is used to form the encapsulant 5. The sealing gasket 90, for example, may comprise or consist of one of a silicone glue, an epoxy glue, an acrylic adhesive, a polyimide, and a polyurethane. The material that is used to form the sealing gasket 90, for example, may be much thicker and much more viscous as compared to the encapsulation material that is used to form the encapsulant 5. In this way, the material that is used to form the sealing gasket 90 will not penetrate into the connector element 22 (i.e. into the cavity 224) due to capillary effects.

According to one example, the sealing gasket 90 consists of a first material, the first material having at least one of a dynamic viscosity of between 10 and 100 Pa*s, a tensile shear strength of at least 0.5 MPa, and a hardness of between 30 Shore A and 90 Shore A, or between 9 Shore C and 59 Shore C, or between 6 Shore D and 39 Shore D. A hardness of 30 Shore A defines comparably soft materials such as rubber bands, for example, while 90 Shore A refers to comparably hard materials such as shopping cart wheels, for example. The Shore C scale is usually used for medium hard materials, and the Shore D scale partly covers rubbers and polyurethanes as well as part of known plastics such as, e.g., Teflon, polypropylenes and polystyrenes. The Shore A, Shore C and Shore D scales partly overlap. It would generally also be possible to use the Shore B (e.g., between 15 and 65 Shore B) or Shore 00 scale (e.g., between 65 and 100 Shore 00) in the present case. A hardness of 70 on the Shore A scale, for example, is comparable to a hardness of about 98 on the Shore 00 scale, a hardness of 10 on the Shore B scale, a hardness of 42 on the Shore C scale, or a hardness of 25 on the Shore D scale. Most soft, medium soft and medium hard rubbers have a hardness of between about 20 and about 90 on the Shore A scale.

The first material may be at least one of a thermally cured material, an addition cured material, a condensation cured material, a UV cured material, and a radically cured material, for example. According to one example, the sealing gasket 90 consists of a thixotropic material. Thixotropic materials generally are odd solids and fluids that change their viscosity (that become less viscous) when loaded by stress. The first material may have a saturated connective structure with only few oligomer components included therein such that no or only insignificant amounts of fluids (e.g., water) leak out of the sealing gasket 90.

The connector element 22 is attached to, and the sealing gasket 90 is formed on the electronics carrier 10, 81 before the electronics carrier 10, 81 is arranged in a housing 7 of a semiconductor module arrangement 100. A (pre-produced) electronics carrier 10, 81 according to embodiments of the disclosure comprises a connector element 22 arranged on and electrically coupled to the electronics carrier 10, 81, and a sealing gasket 90 surrounding a lower end of the connector element 22, wherein the lower end is an end of the connector element 22 facing the electronics carrier 10, 81, and wherein the sealing gasket 90 is arranged to seal a gap between the lower end of the connector element 22 and the electronics carrier 10, 81. Forming the sealing gasket 90 before arranging the electronics carrier 10, 81 in a housing 7 generally allows to easily access the electronics carrier 10, 81, i.e. the connector element 22 arranged on the electronics carrier 10, 81, by means of suitable tools that are required to form the sealing gasket 90.

A method for producing a semiconductor module arrangement 100 according to embodiments of the disclosure comprises arranging a connector element 22 on an electronics carrier 10, 81 for a semiconductor module arrangement 100, and forming a sealing gasket 90 such that the sealing gasket 90 surrounds a lower end of the connector element 22, wherein the lower end is an end of the connector element 22 facing the electronics carrier 10, 81, and wherein the sealing gasket 90 is arranged to seal a gap between the lower end of the connector element 22 and the electronics carrier 10, 81.

As has been described above, the connector element 22 comprises a plurality of electrical ports 222 and an electrically insulating casing 220, wherein each of the plurality of electrical ports 222 is partly molded into the electrically insulating casing 220, and arranging the connector element 22 on the electronics carrier 10, 81 may comprise electrically and mechanically coupling each electrical port 222 of the plurality of electrical ports 222 to the electronics carrier 10, 81. For example, the electrical ports 222 may be electrically coupled (e.g., soldered or sintered) to conductive tracks formed on a printed circuit board 81, or to different sections of a first metallization layer 111 of a substrate 10.

As mentioned above, the electronics carrier 10, 81 may be pre-produced. It is, however, also possible that at least the sealing gasket 90 is only formed after the electronics carrier 10, 81 has been arranged in the housing 7 of the semiconductor module arrangement 100. A sealing gasket 90 may be formed, for example, by means of a needle valve or a pneumatically or a piezo-controlled jet valve. Such tools are usually able to reach the connector element 22 inside the housing 7, even if further components are already arranged on the electronics carrier 10, 81 and space is limited. A curing step may be required in some cases, after forming the sealing gasket 90 on the electronics carrier 10, 81.

Figure 7 schematically illustrates a semiconductor module arrangement 100 according to embodiments of the disclosure. The semiconductor module arrangement 100 comprises a connector element 22 mounted on a first surface of a printed circuit board 81. Instead of on a printed circuit board 81, the connector element 22 may also be mounted on another electronics carrier such as a substrate 10, similar to what has been described with respect to Figure 2. Some connector elements 22 comprise electrical ports 222 that extend through corresponding through holes provided in a printed circuit board 81. That is, the connector element 22 is arranged on a first side of the printed circuit board 81, and the electrical ports 222 extend from the first side through the printed circuit board 81 to an opposite side of the printed circuit board 81. This is schematically illustrated in Figure 8. In such cases, encapsulation material could also penetrate through the through holes provided in the printed circuit board 81 and from there through microscopic cavities formed between the electrical ports 222 and the casing 220. In order to prevent this, the sealing gasket 90 may also be applied to a bottom side of the printed circuit board 81, covering the electrical ports 222 and any gaps formed between the electric ports 22 and the printed circuit board 81, as is schematically illustrated in Figure 8.

## Claims

1. An electronics carrier (10, 81) for a semiconductor module arrangement (100), the electronics carrier (10, 81) comprising
a connector element (22) arranged on and electrically coupled to the electronics carrier (10, 81); and
a sealing gasket (90) surrounding a lower end of the connector element (22), wherein the lower end is an end of the connector element (22) facing the electronics carrier (10), and wherein a strand of sealing gasket (90) extends around the entire circumference of the connector element (22) and seals a gap between the lower end of the connector element (22) and the electronics carrier (10, 81), wherein
the connector element (22) comprises a plurality of electrical ports (222) and an electrically insulating casing (220), wherein the casing (220) provides a cavity (224) surrounded by sidewalls of the connector element (22), and the electrical ports (222) extend into the cavity (224) with a first end, and wherein each of the plurality of electrical ports (222) is partly molded into the electrically insulating casing (220).

2. A semiconductor module arrangement (100) comprises,
a housing (7); and
an electronics carrier (10, 81) according to claim 1, wherein
the electronics carrier (10, 81) is arranged inside the housing (7) or forms a bottom of the housing (7).

3. The semiconductor module arrangement (100) of claim 2, wherein the electronics carrier (10, 81) is a substrate (10) comprising a ceramic substrate layer (11) and a first metallization layer (111) deposited on a first side of the ceramic substrate layer (11).

4. The semiconductor module arrangement (100) of claim 2, wherein
the electronics carrier (10, 81) is a printed circuit board (81),
the semiconductor module arrangement (100) further comprises a substrate (10) arranged inside or forming a bottom of the housing (7), and
the printed circuit board (81) is arranged inside the housing (7), vertically above and in parallel to the substrate (10).

5. The semiconductor module arrangement (100) of any of claims 2 to 4, further comprising an encapsulant (5) at least partly filling the interior of the housing (7), thereby covering the electronics carrier (10, 81) and the sealing gasket (90), and partly covering the connector element (22).

6. The semiconductor module arrangement (100) of any of claims 2 to 5, wherein the sealing gasket (90) comprises or consists of one of a silicone glue, an epoxy glue, an acrylic adhesive, a polyimide, and a polyurethane.

7. The semiconductor module arrangement (100) of any of claims 2 to 6, wherein the sealing gasket (90) consists of a first material, the first material having at least one of:
a tensile shear strength of at least 0.5 MPa; and
a hardness of between 30 Shore A and 90 Shore A, or between 9 Shore C and 59 Shore C, or between 6 Shore D and 39 Shore D.

8. The semiconductor module arrangement (100) of claim 7, wherein the first material is at least one of a thermally cured material, an addition cured material, a condensation cured material, a UV cured material, and a radically cured material.

9. The semiconductor module arrangement (100) of any of claims 2 to 8, wherein the sealing gasket (90) consists of a thixotropic material.

10. The semiconductor module arrangement (100) of any of claims 2 to 9, wherein the sealing gasket (90) is partly arranged between the connector element (22) and the electronics carrier (10, 81).

11. A method comprising:
arranging a connector element (22) on an electronics carrier (10, 81) for a semiconductor module arrangement (100); and
forming a sealing gasket (90) such that the sealing gasket (90) surrounds a lower end of the connector element (22), wherein the lower end is an end of the connector element (22) facing the electronics carrier (10, 81), and wherein a strand of sealing gasket (90) extends around the entire circumference of the connector element (22) and seals a gap between the lower end of the connector element (22) and the electronics carrier (10, 81), wherein
the connector element (22) comprises a plurality of electrical ports (222) and an electrically insulating casing (220), wherein the casing (220) provides a cavity (224) surrounded by sidewalls of the connector element (22), and the electrical ports (222) extend into the cavity (224) with a first end, and wherein each of the plurality of electrical ports (222) is partly molded into the electrically insulating casing (220).

12. The method of claim 11, wherein the sealing gasket (90) is formed by means of a needle valve or a pneumatically or a piezo-controlled jet valve.

13. The method of claim 11 or 12, further comprising a curing step, after forming the sealing gasket (90) on the electronics carrier (10, 81), wherein the sealing gasket (90) consists of a first material, the first material having a dynamic viscosity of between 10 and 100 Pa*s.

14. The method of any of claims 11 to 13, wherein arranging the connector element (22) on the electronics carrier (10, 81) comprises electrically and mechanically coupling each electrical port (222) of the plurality of electrical ports (222) to the electronics carrier (10, 81).

## Patentansprüche

1. Elektronikträger (10, 81) für eine Halbleitermodulanordnung (100), wobei der Elektronikträger (10, 81) Folgendes umfasst:
ein Verbinderelement (22), das auf dem Elektronikträger (10, 81) angeordnet und elektrisch mit diesem gekoppelt ist; und
eine Dichtung (90), die ein unteres Ende des Verbinderelements (22) umgibt, wobei das untere Ende ein Ende des Verbinderelements (22) ist, das dem Elektronikträger (10) zugewandt ist, und wobei sich ein Strang von Dichtungen (90) um den gesamten Umfang des Verbinderelements (22) erstreckt und einen Spalt zwischen dem unteren Ende des Verbinderelements (22) und dem Elektronikträger (10, 81) abdichtet, wobei
das Verbinderelement (22) mehrere elektrische Anschlüsse (222) und ein elektrisch isolierendes Gehäuse (220) umfasst, wobei das Gehäuse (220) einen Hohlraum (224) bereitstellt, der von Seitenwänden des Verbinderelements (22) umgeben ist, und sich die elektrischen Anschlüsse (222) mit einem ersten Ende in den Hohlraum (224) erstrecken, und wobei jeder der mehreren elektrischen Anschlüsse (222) teilweise in das elektrisch isolierende Gehäuse (220) geformt ist.

2. Halbleitermodulanordnung (100), umfassend:
ein Gehäuse (7); und
einen Elektronikträger (10, 81) nach Anspruch 1, wobei der Elektronikträger (10, 81) innerhalb des Gehäuses (7) angeordnet ist oder einen Boden des Gehäuses (7) bildet.

3. Halbleitermodulanordnung (100) nach Anspruch 2, wobei der Elektronikträger (10, 81) ein Substrat (10) ist, das eine Keramiksubstratschicht (11) und eine erste Metallisierungsschicht (111), die auf einer ersten Seite der Keramiksubstratschicht (11) abgeschieden ist, umfasst.

4. Halbleitermodulanordnung (100) nach Anspruch 2, wobei
der Elektronikträger (10, 81) eine Leiterplatte (81) ist, die Halbleitermodulanordnung (100) ferner ein Substrat (10) umfasst, das innerhalb des Gehäuses (7) angeordnet ist oder einen Boden davon bildet, und
die Leiterplatte (81) innerhalb des Gehäuses (7) vertikal über und parallel zu dem Substrat (10) angeordnet ist;

5. Halbleitermodulanordnung (100) nach einem der Ansprüche 2 bis 4, die ferner ein Verkapselungsmittel (5) umfasst, das das Innere des Gehäuses (7) zumindest teilweise füllt, wodurch der Elektronikträger (10, 81) und die Dichtung (90) bedeckt sind und das Verbinderelement (22) teilweise bedeckt ist.

6. Halbleitermodulanordnung (100) nach einem der Ansprüche 2 bis 5, wobei die Dichtung (90) einen Silikonklebstoff, einen Epoxidklebstoff, einen Acrylklebstoff, ein Polyimid und/oder ein Polyurethan umfasst oder daraus besteht.

7. Halbleitermodulanordnung (100) nach einem der Ansprüche 2 bis 6, wobei die Dichtung (90) aus einem ersten Material besteht, wobei das erste Material mindestens eines der Folgenden aufweist:
eine Zugscherfestigkeit von mindestens 0,5 MPa; und
eine Härte zwischen 30 Shore A und 90 Shore A oder zwischen 9 Shore C und 59 Shore C oder zwischen 6 Shore D und 39 Shore D.

8. Halbleitermodulanordnung (100) nach Anspruch 7, wobei das erste Material ein thermisch gehärtetes Material und/oder ein additionsgehärtetes Material und/oder ein kondensationsgehärtetes Material und/oder ein UV-gehärtetes Material und/oder ein radikalisch gehärtetes Material ist.

9. Halbleitermodulanordnung (100) nach einem der Ansprüche 2 bis 8, wobei die Dichtung (90) aus einem thixotropen Material besteht.

10. Halbleitermodulanordnung (100) nach einem der Ansprüche 2 bis 9, wobei die Dichtung (90) teilweise zwischen dem Verbinderelement (22) und dem Elektronikträger (10, 81) angeordnet ist.

11. Verfahren, das Folgendes umfasst:
Anordnen eines Verbinderelements (22) auf einem Elektronikträger (10, 81) für eine Halbleitermodulanordnung (100); und
Bilden einer Dichtung (90), so dass die Dichtung (90) ein unteres Ende des Verbinderelements (22) umgibt, wobei das untere Ende ein Ende des Verbinderelements (22) ist, das dem Elektronikträger (10, 81) zugewandt ist, und wobei sich ein Strang von Dichtungen (90) um den gesamten Umfang des Verbinderelements (22) erstreckt und einen Spalt zwischen dem unteren Ende des Verbinderelements (22) und dem Elektronikträger (10, 81) abdichtet, wobei das Verbinderelement (22) mehrere elektrische Anschlüsse (222) und ein elektrisch isolierendes Gehäuse (220) umfasst, wobei das Gehäuse (220) einen Hohlraum (224) bereitstellt, der von Seitenwänden des Verbinderelements (22) umgeben ist, und sich die elektrischen Anschlüsse (222) mit einem ersten Ende in den Hohlraum (224) erstrecken, und wobei jeder der mehreren elektrischen Anschlüsse (222) teilweise in das elektrisch isolierende Gehäuse (220) geformt ist.

12. Verfahren nach Anspruch 11, wobei die Dichtung (90) mittels eines Nadelventils oder eines pneumatisch oder piezoelektrisch gesteuerten Strahlventils gebildet wird.

13. Verfahren nach Anspruch 11 oder 12, ferner umfassend einen Aushärtungsschritt nach dem Bilden der Dichtung (90) auf dem Elektronikträger (10, 81), wobei die Dichtung (90) aus einem ersten Material besteht, wobei das erste Material eine dynamische Viskosität zwischen 10 und 100 Pa*s aufweist.

14. Verfahren nach einem der Ansprüche 11 bis 13, wobei das Anordnen des Verbinderelements (22) auf dem Elektronikträger (10, 81) elektrisches und mechanisches Koppeln jedes elektrischen Anschlusses (222) der mehreren elektrischen Anschlüsse (222) mit dem Elektronikträger (10, 81) umfasst.

## Revendications

1. Un support (10, 81) d'électronique pour un agencement (100) de module à semiconducteur, le support (10, 81) d'électronique comprenant
un élément (22) connecteur monté sur le et connecté électriquement au support (10, 81) d'électronique ; et
une garniture (90) d'étanchéité entourant une extrémité inférieure de l'élément (22) connecteur, dans lequel l'extrémité inférieure est une extrémité de l'élément (22) connecteur faisant face au support (10) d'électronique, et dans lequel un tronçon de la garniture (90) d'étanchéité s'étend autour de toute la circonférence de l'élément (22) connecteur et rend étanche un intervalle entre l'extrémité inférieure de l'élément (22) connecteur et le support (10, 81) d'électronique, dans lequel
l'élément (22) connecteur comprend une pluralité d'accès (222) électriques et une boîte (220) isolante électriquement, dans lequel la boîte (220) ménage une cavité (224) entourée par des parois latérales de l'élément (22) connecteur, et les accès (222) électriques s'étendent dans la cavité (224) par une première extrémité, et dans lequel chacun de la pluralité d'accès (222) électriques est moulé en partie dans la boîte (220) isolante électriquement.

2. Un agencement (100) de module à semiconducteur comprend
un boîtier (7) ; et
un support (10, 81) d'électronique suivant la revendication 1, dans lequel
le support (10, 81) d'électronique est disposé à l'intérieur du boîtier (7) pour former le fond du boîtier (7).

3. L'agencement (100) de module à semiconducteur de la revendication 2, dans lequel le support (10, 81) d'électronique est un substrat (10) comprenant une couche (11) de substrat en céramique et une première couche (111) de métallisation disposée sur une première face de la couche (11) de substrat en céramique.

4. L'agencement (100) de module à semiconducteur de la revendication 2, dans lequel
le support (10, 81) d'électronique est une plaquette (81) à circuit imprimé,
l'agencement (100) de module à semiconducteur, comprend, en outre un substrat (10) disposé à l'intérieur ou formant un fond du boîtier (7), et
la plaquette (81) à circuit imprimé est disposée à l'intérieur du boîtier (7) au-dessus verticalement du substrat (10) et parallèlement à celui-ci.

5. L'agencement (100) de module à semiconducteur de l'une quelconque des revendications 2 à 4, comprenant, en outre, un encapsulant (5) remplissant au moins en partie l'intérieur du boîtier (7) en recouvrant ainsi le support (10, 81) d'électronique et la garniture (90) d'étanchéité et recouvrant en partie l'élément (22) connecteur.

6. L'agencement (100) de module à semiconducteur de l'une quelconque des revendications 2 à 5, dans lequel la garniture (90) d'étanchéité comprend ou consiste en l'un d'une colle de silicone, d'une colle d'époxy, d'un adhésif acrylique, d'un polyimide et d'un polyuréthane.

7. L'agencement (100) de module à semiconducteur de l'une quelconque des revendications 2 à 6, dans lequel la garniture (90) d'étanchéité consiste en un premier matériau, le premier matériau ayant au moins l'un de :
une résistance au cisaillement à la traction d'au moins 0,5 MPa ; et
une dureté comprise entre 30 Shore A et 90 Shore A ou entre 9 Shore C et 59 Shore C, ou entre 6 Shore D et 39 Shore D.

8. L'agencement (100) de module à semiconducteur de la revendication 7, dans lequel le premier matériau est au moins l'un d'un matériau durci thermiquement, d'un matériau durci par addition, d'un matériau durci par condensation, d'un matériau durci par UV et d'un matériau durci par radicaux.

9. L'agencement (100) de module à semiconducteur de l'une quelconque des revendications 2 à 8, dans lequel la garniture (90) d'étanchéité consiste en un matériau thixotrope.

10. L'agencement (100) de module à semiconducteur de l'une quelconque des revendications 2 à 9, dans lequel la garniture (90) d'étanchéité est disposée en partie entre l'élément (22) connecteur et le support (10, 81) d'électronique.

11. Un procédé comprenant :
mettre un élément (22) connecteur sur un support (10, 81) d'électronique pour un agencement (100) de module à semiconducteur ; et
former une garniture (90) d'étanchéité, de manière à ce que la garniture (90) d'étanchéité entoure une extrémité inférieure de l'élément (22) connecteur, dans lequel l'élément inférieur est une extrémité de l'élément (22) connecteur faisant face au support (10, 81) d'électronique, et dans lequel un tronçon de la garniture (90) d'étanchéité s'étend autour de toute la circonférence de l'élément (22) connecteur et rend étanche un intervalle entre l'extrémité inférieure de l'élément (22) connecteur et le support (10, 81) d'électronique, dans lequel
l'élément (22) connecteur comprend une pluralité d'accès (222) électriques et une boîte (220) isolante électriquement, dans lequel la boîte (220) ménage une cavité (224) entourée par des parois latérales de l'élément (22) connecteur, et les accès (222) électriques s'étendent dans la cavité (224) par une première extrémité, et dans lequel chacun de la pluralité d'accès (222) électriques est moulé en partie dans la boîte (220) isolante électriquement.

12. Le procédé de la revendication 11, dans lequel la garniture (90) d'étanchéité est formée au moyen d'une soupape à aiguille ou d'une soupape à jet piézo-commandée ou commandée pneumatiquement.

13. Le procédé de la revendication 11 ou 12, comprenant, en outre, un stade de durcissement après avoir formé la garniture (90) d'étanchéité sur le support (10, 81) d'électronique, dans lequel la garniture (90) d'étanchéité consiste en un premier matériau, le premier matériau ayant une viscosité dynamique comprise entre 10 et 100 Pa*s.

14. Le procédé de l'une quelconque des revendications 11 à 13, dans lequel mettre l'élément (22) connecteur sur le support (10, 81) d'électronique comprend accoupler électriquement et mécaniquement chaque accès (222) électrique de la pluralité d'accès (222) électriques au support (10, 81) d'électronique.
